# EUROPEAN PATENT SPECIFICATION

(11) **EP 1 452 081 B1**
(45) Date of publication and mention of the grant of the patent: **22.12.2010**
(21) Application number: 02802772.0
(22) Date of filing: 27.09.2002
(51) Int. Cl.: H05K 13/04

(54) **RETRACTABLE VACUUM TUBE FOR POSITIONING ELECTRONIC COMPONENTS ON PRINTED CIRCUIT BOARDS**
ZURÜCKZIEHBARE VAKUUMRÖHRE ZUM POSITIONIEREN ELEKTRONISCHER KOMPONENTEN AUF LEITERPLATTEN
TUBE A VIDE RETRACTABLE POUR LE MONTAGE DE COMPOSANTS ELECTRONIQUES SUR DES CARTES DE CIRCUITS IMPRIMES

(30) Priority: 02.11.2001 US 53252
(43) Date of publication of application: 01.09.2004
(73) Proprietor: Delaware Capital Formation, Inc., Wilmington, DE 19803 (US)
(72) Inventor: CARLOMAGNO, Mike, Chico, CA 95973 (US); MISHIN, Artem, San Francisco, CA 94131 (US)
(74) Representative: Diehl, Hermann O. Th.
(86) International application number: PCT/US2002/030756
(87) International publication number: WO 2003/041479

(56) References cited:
- WO-A-01/63999
- US-B1- 6 250 538

## Description

### Technical Field

The present invention relates in general to optical positioning systems and in particular to heated gas soldering / desoldering systems for placing or removing integrated circuit chips from printed circuit boards.

### Background of the Invention

The fabrication of modern electronic components typically involves the attachment of electronic components such as integrated circuits onto printed circuit boards. Such integrated circuits are first positioned at the desired location on the circuit board and are then soldered by heated gasses into position. Such positioning and soldering operations require precise control for at least the following reasons.

Integrated circuit chips typically comprise an array of small balls or solder columns which extend downwardly from the back of the chip and/or small leads which extend downwardly from the perimeter of the chip. When assembling electronic systems, the various electronic components are sequentially placed onto a printed circuit board such that the leads extending downwardly therefrom are positioned at desired locations on the printed circuit board, and are then soldered into position. Typically, the placement of such electronic components are carried out by automatic positioning systems which lower the components into position. Different electronic components have different thicknesses. Thicknesses vary not only among different types of electronic components, but also for each particular type of component. For example, modern integrated circuit chips may vary from as little as 0.5 mm to as much as 4.0 mm in thickness.

Accordingly, when positioning components of different thicknesses with an automated placement system, it is necessary to take the thicknesses of the components into account. This must be done such that the balls or leads extending from the bottom surfaces and sides of the components are positioned at the same height (i.e. in precise contact with the surface of the printed circuit board). For example, if the integrated circuit chip is thick, the tool head need not travel as far down when positioning the integrated circuit chip on the printed circuit board. Conversely, if the integrated circuit chip is thin, the tool head need travel slightly farther down when positioning the leads of the integrated circuit chip on the printed circuit board.

Unfortunately, although existing component alignment and placement systems can be used to accurately visually position a component in X and Y directions, (i.e.: back and forth and side-to-side), above the printed circuit board, such alignment systems are not typically able to accurately visually position a component in the Z (i.e. vertical) direction. This is due to the fact that such alignment systems rely on an optical positioning system which views a superimposed image of the component and the printed circuit board. Such an image permits alignment in the horizontal X and Y directions, but not in the vertical Z direction. Therefore, from such images, it is not possible to directly view the downward vertical (i.e. Z) distance which the tool head travels when positioning the electronic component. Thus, the vertical (i.e.: Z) distance which the component positioning head travels when positioning the electronic component travels must be separately pre-programmed into the placement system for each electronic component.

As can be appreciated, as progressively smaller and thinner integrated circuit chips, having more complex solder ball arrays are developed, it becomes more and more difficult to accurately position the integrated circuit chips on the surface of the printed circuit boards. For example, today's integrated circuit chips may have ball arrays as small as 1 mm². Such ball arrays may have a "pitch" (i.e.: the distance between adjacent solder balls) as small as 0.3 mm. Thus, due to the small size of the individual balls in an array, accurately positioning the integrated circuit chip at the exact height so as not to damage such small elements of the chip requires a system which is capable of very accurate controlled vertical movement.

Patent specification US 6,250,538 B discloses an electrical component mounting apparatus with a retaining device containing a suction pipette. The suction pipette comprises three members: a tube member being fixedly attached to the mounting head; a suction tip being movable relative to the tube member 1; and a compensating element connecting the suction tip of the suction pipette to the tube member on the mounting head. A compensating member controls the contact pressure applied to the electrical component when being contacted by the suction pipette to ensure that the electrical component will not be damanged upon being picked up with the suction pipette.

Patent application WO 01/63999 A discloses an electronic component mounting apparatus having a suction nozzle with an outer nozzle member that is slideably accommodated in a nozzle body. A spring placed between the nozzle body and the outer nozzle member urges the outer nozzle member in a direction away from the nozzle body. The spring is compressed upon the suction nozzle picking up an electronic component. The pressure exerted on the electronic component is hereby defined by the spring characteristics.

### Summary of the Invention:

All examples given below which do not fall under the scope of the invention as set out in the appended claims are not to be considered as embodiments and examples of the invention.

The present invention provides a system for positioning components of different thicknesses on a component platform, as recited in claim 1.

The present invention also provides a method of positioning a component on a target surface, as disclosed in claim 5.

In preferred aspects, the components comprise (but are not limited to) electronic components in general, and integrated circuit chips in particular. Also in preferred aspects, the component platform comprises a printed circuit board.

An advantage of the present invention is that it provides a system wherein electronic components of different thicknesses can easily be positioned on a printed circuit board. Specifically, this placement can be accomplished without regard to the exact thicknesses of each of the various electronic components by holding onto the components with a retractable vacuum tube. Rather, as each component is positioned on the printed circuit board, the tool head holding the component need only be moved downwardly the same distance regardless of the thickness of the component. This advantage is achieved by the vacuum tube holding the component retracting different distances into the tool head depending upon the thickness of the component which it is holding.

A further advantage of the present system is that components can be picked for placement without the vacuum tube exerting too great a downward pressure on the component. Such pressure is to be avoided at it may damage the fragile solder ball array on the underside of the chip. This advantage is due to the fact that the present vacuum tube retracts into the tool head when picking up the component.

Thus, the present invention facilitates rapid component placement, thereby increasing overall assembly speed and efficiency.

### Brief Description of the Drawings:

Fig. 1A is a perspective view of the present invention, with the optical system retracted, prior to component placement.
Fig. 1B is a perspective view of the present invention, with the optical system extended, prior to component placement.
Fig. 1C is a perspective view of the present invention, with the optical system retracted, at the time of component placement.
Fig. 2A is a side elevation view of the present invention, corresponding to Fig. 1A.
Fig. 2B is a side elevation view of the present invention, corresponding to Fig. 1B.
Fig. 2C is a side elevation view of the present invention, corresponding to Fig. 1C.

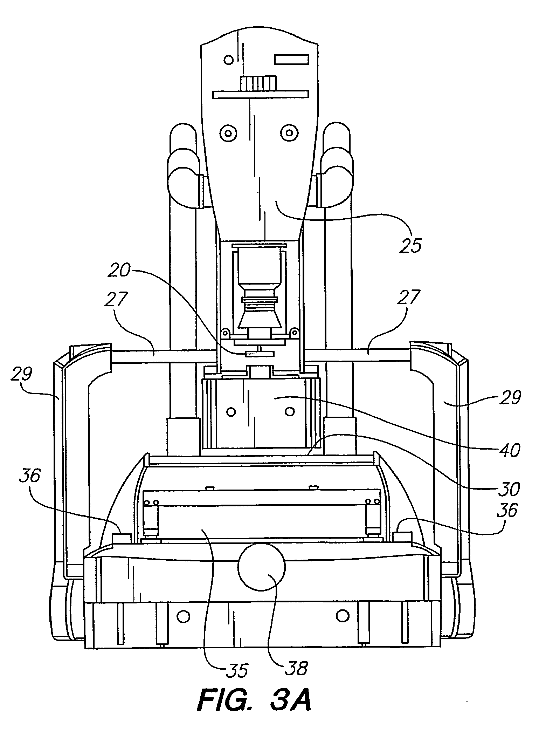

Fig. 3A is a front elevation view of the present invention corresponding to Figs. 1A and 1B.

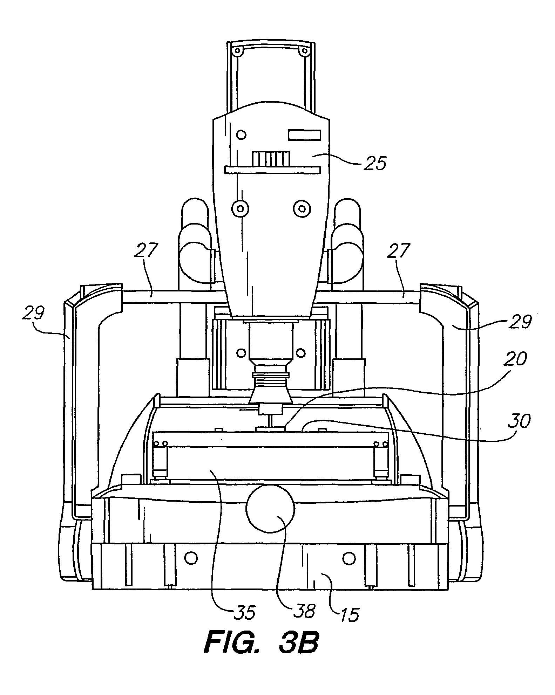

Fig. 3B is a front elevation view of the present invention corresponding to Fig. 1C.
Figs. 4A to 4C show sequential steps in picking up of an electronic component for placement, as follows.

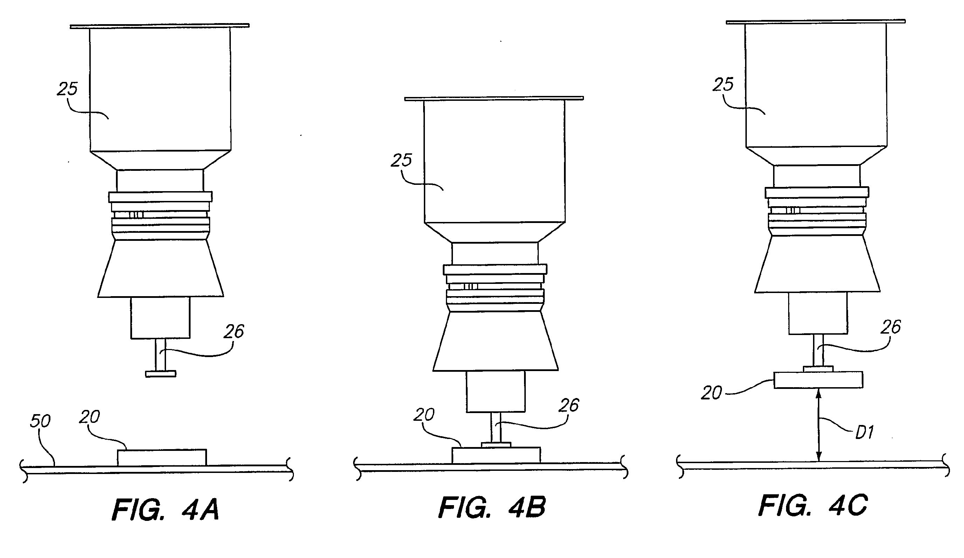

Fig. 4A is side elevation view of the present invention prior to picking up the electronic component, showing a movable tool head (having a movable vacuum tube received therein) positioned over the electronic component.
Fig. 4B is a side elevation view showing the tool head of Fig. 4A after it has been lowered to pick up the electronic component.
Fig. 4C is a side elevation view showing the tool head of Fig. 4B after it has been raised, thereby lifting the electronic component.

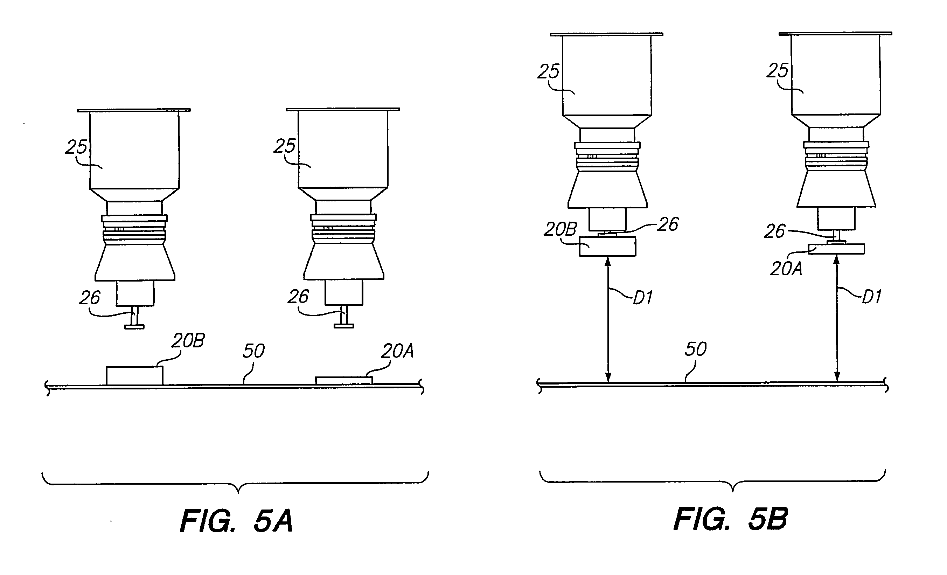

Fig. 5A is a side-by-side comparison showing the present movable tool head positioned to lift electronic components of different thicknesses.
Fig. 5B is a side-by-side comparison showing the present movable tool head lifting electronic components of different thicknesses.

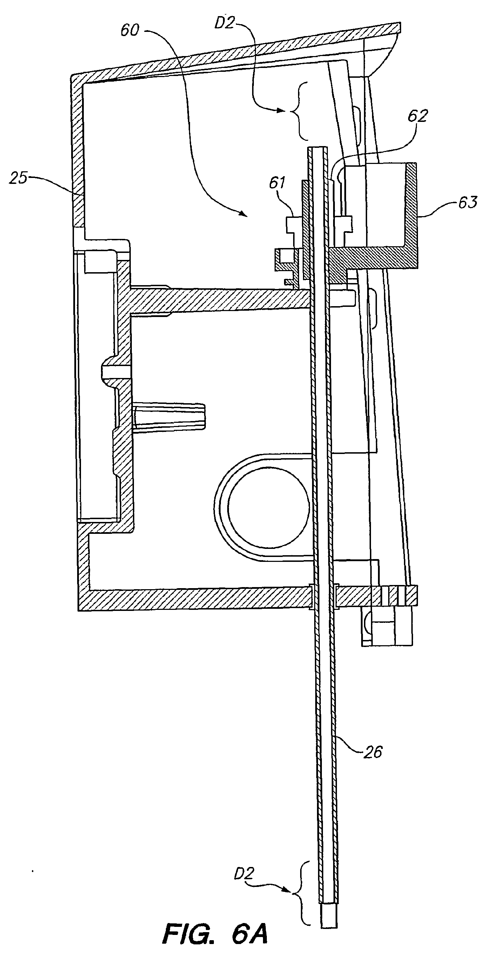

Fig. 6A is an cross sectional view of the tool head of the present invention, showing the vacuum tube in an extended position.

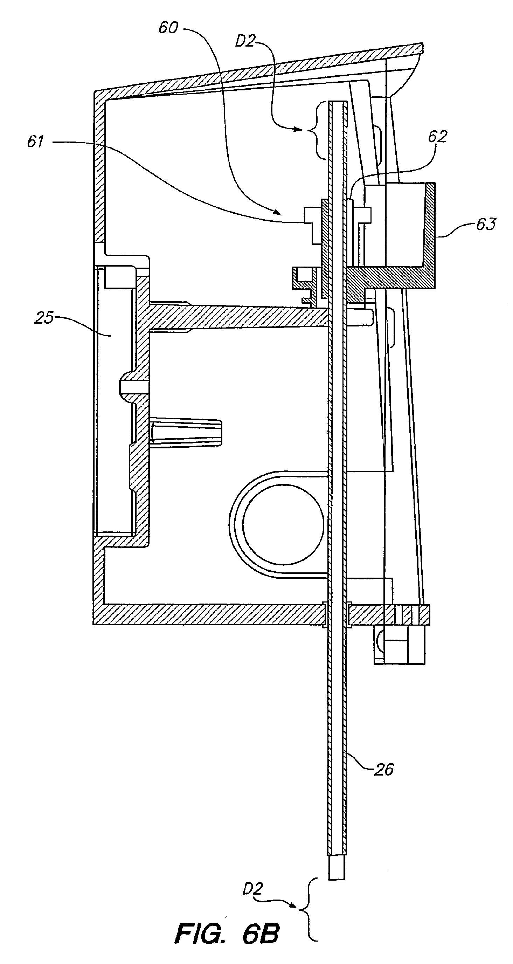

Fig. 6B is an cross sectional view of the tool head of the present invention, showing the vacuum tube in a retracted position.

### Detailed Description of the Preferred Embodiments

Referring to the attached Figs., the present system provides an alignment system 10 for positioning an electronic component 20 at a preferred (i.e.: target) location 31 on a printed circuit board 30 or other pad or substrate. Component 20 is held in position by a vacuum tube 26 extending downwardly from movable tool head 25. Similarly, printed circuit board 30 is held in position by a movable component platform 35.

Alignment system 10 comprises a frame 15 to which both tool head 25 and component platform 35 are attached. In accordance with the present invention, both tool head 25 and component platform 35 are separately positionable in X and Y directions.

In optional preferred aspects, vacuum tube 26 is rotatable about its longitudinal axis, thereby permitting component-to-board alignment in a further dimension (i.e.: component 20 can be rotated into a preferred position above component platform 30, prior to placement).

Electronic component 20 preferably comprises an integrated circuit chip having an array of ball solder leads 21 on its underside or edges. It is to be understood, however, that electronic component 20 is not limited only to integrated circuit chip, but may instead comprise any sort of electrical or non-electrical component. Additionally, tool head 25 may preferably comprise a heated gas soldering / desoldering tool head, but also is not so limited. Rather, tool head 25 may comprise any sort of component positioning head or substance (e.g.: gel /glue) application head.

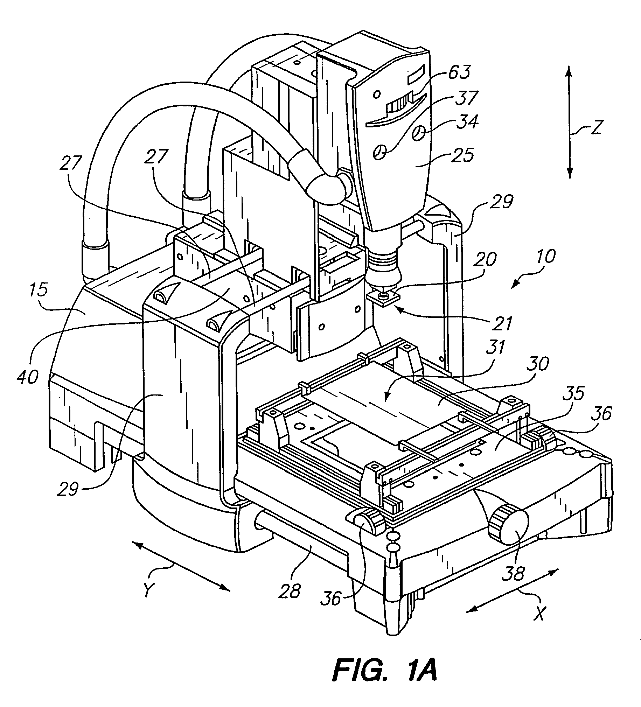

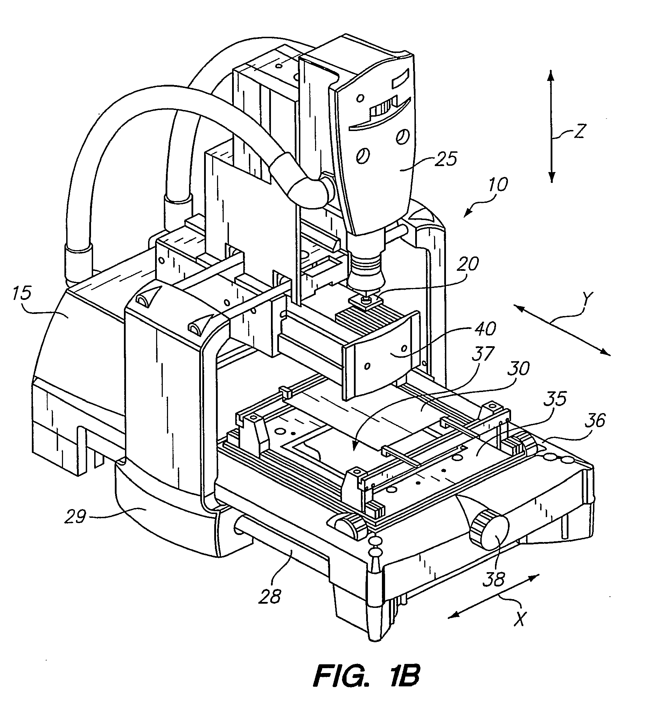

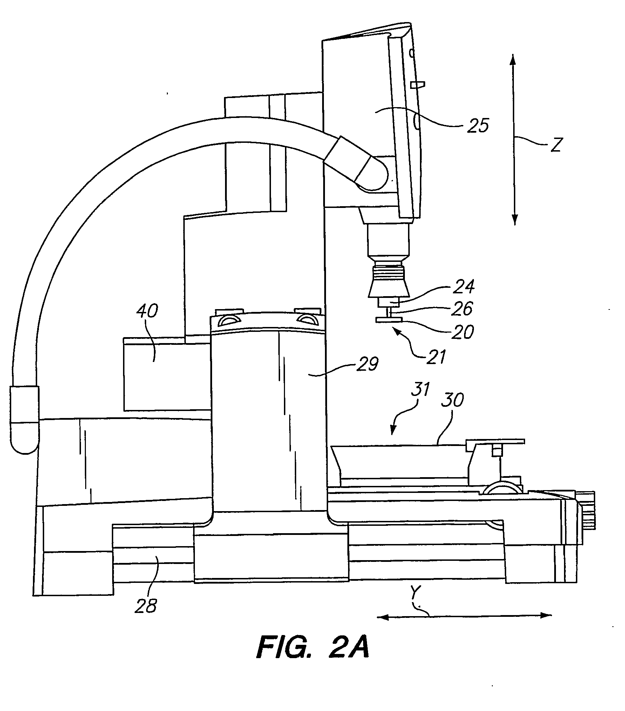

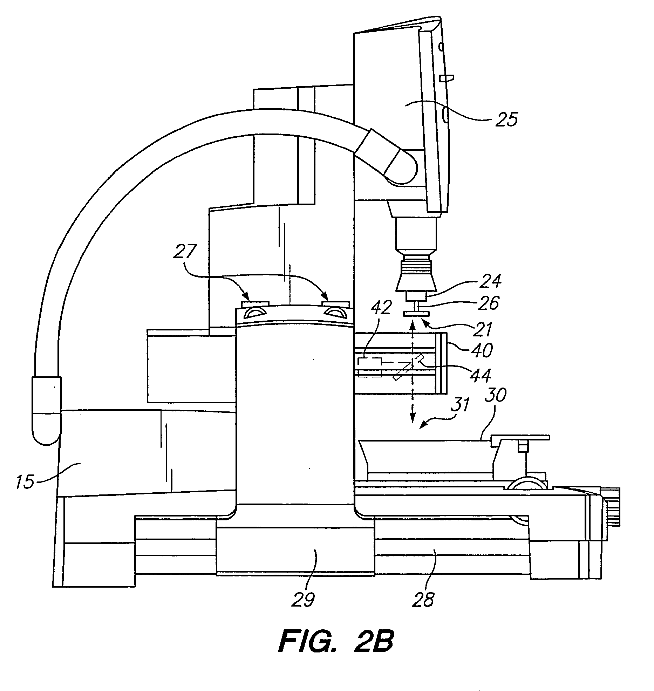

In accordance with the present invention, electronic component 20 is positioned at target location 31 on printed circuit board 30 using retractable optical system 40, as follows. Retractable optical system 40 is slidably movable between a "pushed in" or "retracted" position (as shown in Figs. 1A and 2A) and a "pulled out" or "extended" position (as shown in Figs. 1B and 2B). As shown in Fig. 2B, retractable optical system 40 preferably comprises an internal camera 42 and a beam splitter 44 (shown in dotted lines).

Initially, prior to component placement, as shown in Figs. 1B and 2B, assembly 40 is "pulled out". At this time, camera 42 views an image through beam splitter 42 such that it simultaneously views leads 21 on component 20 and target area 31 on printed circuit board 30. With optical assembly 40 "pulled out", tool head 25 is then moved (in X and Y directions) such that component 20 is positioned roughly above target area 31. Such movement comprises a "coarse" positioning.

Manual movement of tool head 25 in the X and Y directions is achieved as follows. Tool head 25 is slidably positionable along rods 27. Thus, tool head 25 may be slidably positioned side-to-side along rods 27 in the X direction. Similarly, positioning arms 29 are slidably movable along rods 28 such that arms 29 be slidably positioned back and forth in the Y direction. Such X and Y movement of tool head 25 comprises "coarse" alignment of tool head 25 and target region 31. Preferably, as shown in Fig. 1A , the operator may push button 34 to unlock movement of tool head 25 (along rods 27), or may push button 37 to unlock movement of positioning arms 29 (along rods 28). Thus, tool head 25 is preferably separately positionable in either of the X and Y directions (while movement in the other direction is prevented) by the operator depressing buttons 34 and 37 separately. This optional feature of the invention further assists in accurate component alignment as the tool head can be manually positioned first in the X direction, and then in the Y direction (or vice versa).

After positioning tool head 25, component platform 35 is then moved (in X and Y directions) such that printed circuit board 30 is then positioned in precise alignment with component 20. Such movement comprises "fine" positioning alignment. In preferred aspects, manually adjustable knobs 36 and 38 can be used to rotate fine positioning screws which move component platform 35. For example, knob 36 can be used to move component platform 35 in the X direction and knob 38 can be used to move component platform 35 in the Y direction. The positioning screws which are rotated by knobs 36 and 38 preferably comprise "micrometer" adjustment screws. For example, in preferred aspects, a suitable pitch for such positioning screws ranges from 20 to 100 rotations per inch. In an exemplary embodiment of the invention constructed by the Applicants, a positioning screw having a pitch of 48 turns per inch was used. Such micrometer scale screws permit precise X and Y directional alignment between component 20 and target region 31 to be accomplished manually. In an exemplary embodiment of the invention constructed by the Applicants, component platform 35 is dimensioned large enough to handle a 8" by 10" printed circuit board 30. To achieve precise positional alignment, it was only necessary for component platform 35 to move printed circuit board 30 by small distances (specifically, on the order of plus or minus 1/4 inch).

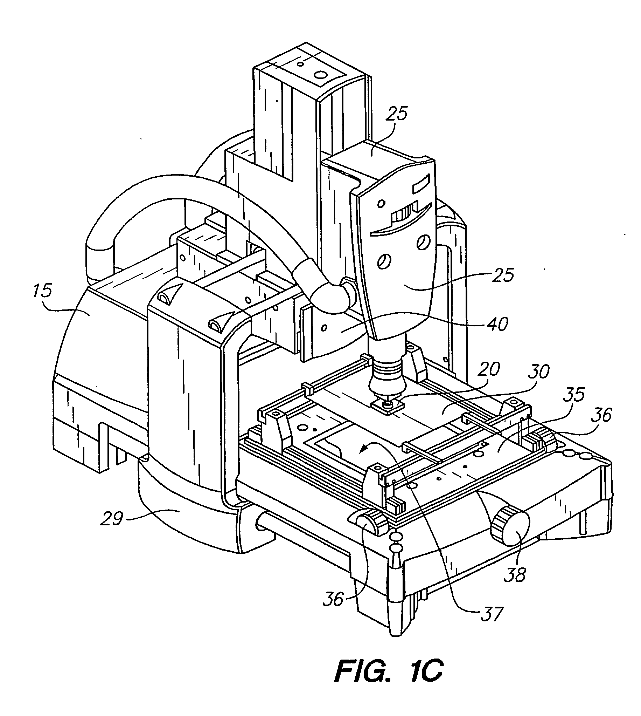

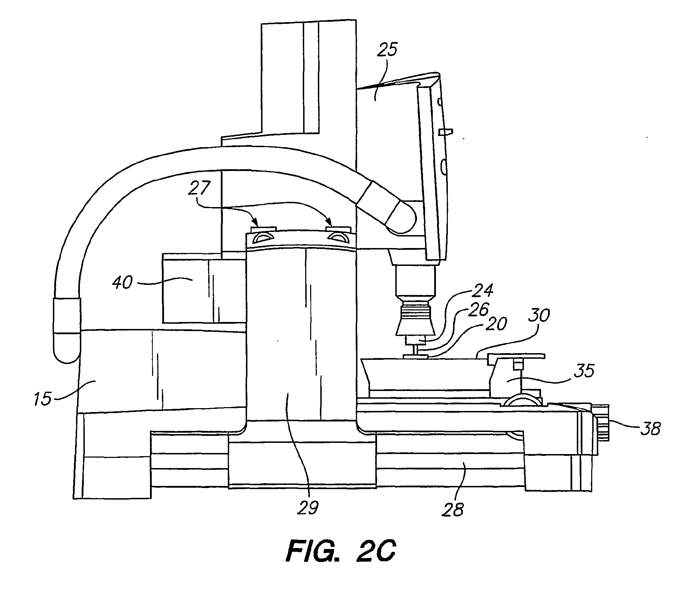

As explained above, and as shown in Fig. 2B, camera 42 takes an image through beam splitter 44 which simultaneously shows the positions of component 20 and printed circuit board 30. After component 20 has been positioned in precise alignment with target region 31 of printed circuit board 30, optical system 40 is then retracted (i.e.: "pushed back in" to the position as was shown in Fig. 1A and 2A). Thereafter, as shown in Figs. 1C and 2C, tool head 25 is then lowered (i.e.: moved downwardly in the Z direction) such that component 20 is positioned directly on printed circuit board 30. In preferred aspects, this downward movement is controlled by stepper motors such that precise Z directional movement is achieved. Precise mechanical lowering of tool head 25 thus ensures that component 20 is positioned at an appropriate height such that its leads 21 just touch printed circuit board 30.

At this time, heater 24 (which surrounds vacuum tube 26) emits a heated gas which heats component 20 such that its array of leads 21 solders into the preferred target location 31 on printed circuit board 30. In addition, heated gas is also passed upwardly through pre-heater 37 (positioned under component platform 35), thereby directly heating a lower surface the printed circuit board 30. An advantage of heating printed circuit board 30 by pre-heater 37 heating its underside is that the board can be heated to a temperature just less than the melting point of the solder. Accordingly, only a small amount of heat needs to be applied from above component 20 through heater 24 in tool head 25 to solder electronic component 20 into position. In the absence of heat applied upwardly through pre-heater 37 under component platform 35, it would be necessary to apply much more heat with tool head 25 alone. Unfortunately, this may tend to increase thermal shock to the board, causing localized heating, thereby warping the circuit board.

Figs. 4A to 4C show the successive steps of picking an electronic component up from a first location (such as a component tray). Thereafter, the electronic component can be positioned on a component platform or structure disposed on a component platform (such as a printed circuit board).

Referring first to Fig. 4A, tool head 25 is shown positioned above electronic component 20. Component 20 is shown positioned on surface 50. Surface 50 may represent any sort of surface on which components are initially provided. For example, surface 50 may represent a tray containing a plurality of similar electrical components which are to be attached to printed circuit boards. Tool head 25 is lowered to the position shown in Fig. 4B in which vacuum tube 26 contacts with, and holds onto component 20. In accordance with the present invention, vacuum tube 26 is at least partially slidably retractable into tool head 25. Therefore, as tool head 25 is moved downwardly to its final lowered position as shown in Fig. 4B, vacuum tube 26 is at least partially retracted into tool head. By retracting, vacuum tube 26 advantageously avoids downward pushing of component 20 when picking up the component. Such downward pushing on the top of the component may tend to damage the fragile solder balls or leads extending downwardly from the bottom surface of the component.

After vacuum tube 26 has been retracted, (i.e. when downward movement of tool head 25 stops), vacuum tube 26 is then locked into position such that it does not move within tool head 25. As will be explained herebelow, vacuum tube 26 can be held in a fixed position within tool head 25 by a collet assembly. It is to be understood, however, that the present invention encompasses any suitable system for holding vacuum tube 26 in a fixed position within tool head 25.

As shown in Fig. 4C, after vacuum tube 26 is secured in a fixed position within tool head 25, tool head 25 can then be raised by distance D1, such that it lifts electronic component 20 by a distance D1 away from surface 50. Thereafter, tool head 25 can be position over a target location on a component platform. Such positioning can be accomplished by moving the tool head, moving the component platform, or more preferably, by moving both.

Thereafter, tool head 25 can then be lowered into a position (similar to Fig. 4A) such that component 20 is placed directly on top of the printed circuit board 30 (which is held in place by a component platform 35). At this time, component 20 is released by vacuum tube 26, and tool head 25 is then used to solder component 20 into position the component platform 30.

An important advantage of the present invention is that it can be used to easily grasp onto components of different thicknesses, and then accurately position these components on a printed circuit board (or other surface or platform) without regard to the thickness of the individual component, as follows.

Referring to Figs. 5A and 5B, tool head 25 is shown picking up components of different thicknesses (e.g.: a thin component 20A and a thick component 20B). Thus, Fig. 5A illustrates the same step shown in Fig. 4B. (i.e. when tool head 25 has been lowered into the position such that its vacuum tube 26 latches onto and thereby picks up component 20. Similarly, Fig. 5B illustrates the same step shown in Fig. 4C (i.e. when tool head 25 has been raised, thereby lifting the component.

As was explained, tool head 25 is preferably lowered a distance sufficient such that vacuum tube 26 is at least partially retracted within tool head 25 when component 20 is initially picked up. As shown in Fig. 5A, when tool head 25 has been positioned to lift a thinner component 20A, vacuum tube 26 will be received only a short distance into tool head 25. Conversely, when tool head 25 has been positioned to lift a thicker component 20B, vacuum tube 26 will be retracted farther into tool head 25. This is particularly advantageous, as follows.

After vacuum tube 26 has grasped onto component (20A or 20B), vacuum tube 26 will then be locked into position (such that it doesn't move relative to tool head 25). At this time, tool head 25 is raised by distance D1 (Fig. 5B). As can be seen, such lifting results in either of component 20A or 20B being lifted to a position such that their bottom surfaces (and their leads 21 extending therefrom) are held at the same height (D1) above surface 50.

Accordingly, when positioning either of components 20A or 20B on a component platform 30 or other surface, it is only necessary to lower the tool head the same distance (D1) such that the leads 21 of the respective component (20A or 20B) will be placed into direct contact on top of the component platform. For example, if surface 50 is positioned at the same height as printed circuit board 20, it is only necessary to lower tool head by the same distance D1 when positioning leads 21 of the respective component (20A or 20B) on printed circuit board 20. Thus, thick or thin components can be lowered exactly the same distance when being placed on the surface of a printed circuit board.

As explained herein, vacuum tube 26 is preferably received at least partially within tool head 25 after vacuum tube 26 contacts an upper surface of component 20 when tool head 25 is first lowered into position to pick up the component.

In accordance with the present invention, an exemplary system for securely locking vacuum tube 26 in a fixed position within tool head 25 is provided. Referring to Figs. 6A and 6B, a movable bushing and collet assembly 60 is provided. Fig. 6A illustrates vacuum tube 26 in an extended position. After the tool head 25 of Fig. 6A has been lowered into position (with vacuum tube 26 grasping onto a component 20 (not shown), vacuum tube 26 will be pushed by distance D2 upwardly into tool head 25.

As shown in Fig. 6B, after vacuum tube 26 is retracted, bushing 61 (which is preferably spring biased) moves upwardly so as to pinch together collet fingers 61, thereby holding vacuum tube 26 in a fixed position. Collet knob 63 preferably protrudes out of the front of tool head 25 such that an operator can simply manually rotate vacuum tube 26 by rotating knob 63. Thus, a further advantage of the present assembly is that component 20 can be manually rotated (about an axis extending longitudinally through vacuum tube 26) into a preferred alignment for placement on component platform 30. (See knob 63 in Fig. 1A).

Fig. 6A shows bushing 61 pushed downwardly such that collet fingers 62 do not "pinch" against vacuum tube 26, and thus restrict its motion.

A further advantage of this system is that when the present invention senses that vacuum tube 26 has started to retract, it knows that contact has been made with component 20.

## Claims

1. A system for positioning components (20) of different thicknesses on a component platform (35), comprising:
a frame (15); and
a tool head (25) supported by the frame (15) such that the tool head (25) can be moved in X and Y directions, the tool head (25) being vertically movable;
**characterized by** further comprising:
a retractable vacuum tube (26) receivable within the tool head (25); and
a grasping assembly (60) which can be actuated to securely hold the vacuum tube (26) in a fixed position relative to the tool head (25) after the vacuum tube (26) has been at least partially received within the tool head (25), wherein the grasping assembly (60) comprises a collet (62) surrounding said vacuum tube (26), said collet (62) keeps gripping state of said vacuum tube (26) or no-gripping state of said vacuum tube (26), a bushing (61) provided around said collet (62), and a compression spring that urges said bushing (61) such that when said vacuum tube (26) is partially received within the tool head (25) said bushing (61) moves said collet (62) to the no-gripping state, and wherein said grasping assembly (60) further comprises a collet knob (63) for manually rotating the vacuum tube (26) about an axis extending longitudinally therethrough.

2. The system of Claim 1, wherein the components (20) comprise electronic components.

3. The system of Claim 2, wherein the electronic components comprise integrated circuit chips.

4. The system of Claim 1, wherein the component platform (35) comprises a printed circuit board (30).

5. A method of positioning a component (20) on a target surface (31), comprising:
positioning a tool head (25) over the component (20), the tool head having a retractable vacuum tube (26) extending downwardly therefrom, wherein the component platform (35) and the tool head (25) are both attached to a frame (15) of a positioning system (10), and wherein the component platform (35) and the tool head (25) are each separately positionable in X and Y directions;
**characterized by** further comprising:
lowering the tool head (25) until the vacuum tube (26) contacts an upper surface of the component (20) and is pushed into a retracted position within the tool head (25);
securely holding the vacuum tube (26) in a fixed position relative to the tool head (25) after the vacuum tube (26) has been pushed into the retracted position within the tool head (25), wherein the vacuum tube (26) is securely held in the fixed position by a grasping assembly (60) which comprises a bushing (61) which is movable along a collet (62), and wherein the grasping assembly (60) further comprises a collet knob (63) for manually rotating the vacuum tube (26) about an axis extending longitudinally therethrough;
lifting the tool head (25), thereby lifting the component (20) with the vacuum tube (26);
positioning the tool head (25) over the target surface (31);
lowering the tool head (25) such that a bottom surface of the component (20) is positioned in contact with the target surface (31); and
releasing the component (20) from the vacuum tube (26).

6. The method of Claim 5, wherein the vacuum tube (26) is securely held in a fixed position relative to the tool head (25) after the vacuum tube (26) has been pushed into the retracted position within the tool head (25) by:
moving a bushing (61) along a collet (62) within the tool head (25).

7. The method of Claim 5, wherein the component (20) comprises an electronic component.

8. The method of Claim 7, wherein the electronic component (20) comprises an integrated circuit chip.

9. The method of Claim 5, wherein the target surface (31) comprises a printed circuit board (30).

10. The method of Claim 9, further comprising:
placing the printed circuit board (30) on a movable component platform (35); and
positioning the printed circuit board (30) by moving the component platform (35).

## Patentansprüche

1. System zum Positionieren von Komponenten (20) unterschiedlicher Dicke auf einer Komponentenplattform (35), umfassend:
ein Gestell (15); und
einen Werkzeugkopf (25), der von dem Gestell (15) derart getragen wird, dass der Werkzeugkopf (25) in X- und Y-Richtung bewegt werden kann, wobei der Werkzeugkopf (25) vertikal beweglich ist;
**dadurch gekennzeichnet, dass** es ferner umfasst:
eine einfahrbare Vakuumröhre (26), die innerhalb des Werkzeugkopfes (25) aufgenommen werden kann; und
eine Greifanordnung (60), welche betätigt werden kann, um die Vakuumröhre (26) sicher in einer festen Position relativ zu dem Werkzeugkopf (25) zu halten, nachdem die Vakuumröhre (26) wenigstens teilweise innerhalb des Werkzeugkopfes (25) aufgenommen worden ist, wobei die Greifanordnung (60) umfasst: eine die Vakuumröhre (26) umgebende Spannhülse (62), wobei die Spannhülse (62) einen Klemmzustand der Vakuumröhre (26) oder einen Nicht-Klemmzustand der Vakuumröhre (26) bewirkt, eine Buchse (61), die um die Spannhülse (62) herum angeordnet ist, und eine Druckfeder, welche die Buchse (61) derart vorspannt, dass, wenn die Vakuumröhre (26) teilweise innerhalb des Werkzeugkopfes (25) aufgenommen ist, die Buchse (61) die Spannhülse (62) in den Nicht-Klemmzustand verschiebt, und wobei die Greifanordnung (60) ferner einen Spannhülsen-Drehknopf (63) zum manuellen Drehen der Vakuumröhre (26) um eine sich längs durch sie hindurch erstreckende Achse umfasst.

2. System nach Anspruch 1, worin die Komponenten (20) elektronische Komponenten umfassen.

3. System nach Anspruch 2, worin die elektronischen Komponenten integrierte Schaltungschips umfassen.

4. System nach Anspruch 1, worin die Komponentenplattform (35) eine Leiterplatte (30) umfasst.

5. Verfahren zum Positionieren einer Komponente (20) auf einer Zieloberfläche (31), umfassend:
Positionieren eines Werkzeugkopfes (25) über der Komponente (20), wobei der Werkzeugkopf eine einfahrbare Vakuumröhre (26) aufweist, die sich von diesem ausgehend nach unten erstreckt, wobei die Komponentenplattform (35) und der Werkzeugkopf (25) beide an einem Gestell (15) eines Positioniersystems (10) angebracht sind und wobei die Komponentenplattform (35) und der Werkzeugkopf (25) jeweils für sich in X- und Y-Richtung positionierbar sind;
**dadurch gekennzeichnet, dass** es ferner umfasst:
Absenken des Werkzeugkopfes (25), bis die Vakuumröhre (26) eine obere Fläche der Komponente (20) berührt und in eine eingefahrene Position innerhalb des Werkzeugkopfes (25) gedrückt wird;
sicheres Halten der Vakuumröhre (26) in einer festen Position relativ zu dem Werkzeugkopf (25), nachdem die Vakuumröhre (26) in die eingefahrene Position innerhalb des Werkzeugkopfes (25) gedrückt worden ist, wobei die Vakuumröhre (26) von einer Greifanordnung (60) sicher in der festen Position gehalten wird, welche eine Buchse (61) umfasst, die entlang einer Spannhülse (62) verschiebbar ist, und wobei die Greifanordnung (60) ferner einen Spannhülsen-Drehknopf (63) zum manuellen Drehen der Vakuumröhre (26) um eine sich längs durch sie hindurch erstreckende Achse umfasst;
Anheben des Werkzeugkopfes (25), wodurch die Komponente (20) mit der Vakuumröhre (26) angehoben wird;
Positionieren des Werkzeugkopfes (25) über der Zieloberfläche (31);
Absenken des Werkzeugkopfes (25), derart, dass eine untere Seite der Komponente (20) in Kontakt mit der Zieloberfläche (31) gebracht wird; und
Lösen der Komponente (20) von der Vakuumröhre (26).

6. Verfahren nach Anspruch 5, worin die Vakuumröhre (26) sicher in einer festen Position relativ zu dem Werkzeugkopf (25) gehalten wird, nachdem die Vakuumröhre (26) in die eingefahrene Position innerhalb des Werkzeugkopfes (25) gedrückt worden ist durch:
Bewegen einer Buchse (61) entlang einer Spannhülse (62) innerhalb des Werkzeugkopfes (25).

7. Verfahren nach Anspruch 5, worin die Komponente (20) eine elektronische Komponente umfasst.

8. Verfahren nach Anspruch 7, worin die elektronische Komponente (20) einen integrierten Schaltungschip umfasst.

9. Verfahren nach Anspruch 5, worin die Zieloberfläche (31) eine Leiterplatte (30) umfasst.

10. Verfahren nach Anspruch 9, ferner umfassend:
Anordnen der Leiterplatte (30) auf einer verschiebbaren Komponentenplattform (35); und
Positionieren der Leiterplatte (30) durch Verschieben der Komponentenplattform (35).

## Revendications

1. Système pour positionner des composants (20) de différentes épaisseurs sur une plateforme pour composants (35), comprenant :
une structure (15) ;
une tête d'outil (25) supportée par la structure (15), de sorte que la tête d'outil (25) peut être déplacée dans les directions X et Y, la tête d'outil (25) étant mobile verticalement ;
**caractérisé en ce qu'**il comporte en outre :
un tube à vide (26), rétractable, pouvant être reçu au sein de la tête d'outil (25) ; et
un ensemble de saisie (60) qui peut être actionné pour tenir fermement le tube à vide (26) en une position fixe par rapport à la tête d'outil (25) après que le tube à vide (26) a été au moins partiellement reçu au sein de la tête d'outil (25), l'ensemble de saisie (60) comprenant un mandrin (62) entourant ledit tube à vide (26), ledit mandrin (62) maintenant un état de saisie dudit tube à vide (26) ou un état de non-saisie dudit tube à vide (26), une douille (61) prévue autour dudit mandrin (62), et un ressort de compression qui sollicite ladite douille (61) de sorte que, lorsque ledit tube à vide (26) est partiellement reçu au sein de la tête d'outil (25), ladite douille (61) déplace ledit mandrin (62) vers l'état de non-saisie, et ledit ensemble de saisie (60) comprenant, en outre, une molette de mandrin (63) pour faire tourner manuellement le tube à vide (26) autour d'un axe s'étendant longitudinalement au travers dudit tube.

2. Système selon la revendication 1, dans lequel les composants (20) comprennent des composants électroniques.

3. Système selon la revendication 2, dans lequel les composants électroniques comprennent des puces de circuits intégrés.

4. Système selon la revendication 1, dans lequel la plateforme pour composants (35) comprend une carte de circuit imprimé (30).

5. Procédé de positionnement d'un composant (20) sur une surface cible (31), comprenant :
le positionnement d'une tête d'outil (25) sur le composant (20), la tête d'outil ayant un tube à vide (26), rétractable, s'étendant vers le bas depuis ladite tête, la plateforme pour composants (35) et la tête d'outil (25) étant toutes deux fixées à une structure (15) d'un système de positionnement (10), et la plateforme pour composants (35) et la tête d'outil (25) étant chacune, séparément, positionnables dans les directions X et Y ;
le procédé étant **caractérisé en ce qu'**il comprend en outre :
l'abaissement de la tête d'outil (25) jusqu'à ce que le tube à vide (26) vienne en contact avec une surface supérieure du composant (20) et soit poussé jusque dans une position rétractée au sein de la tête d'outil (25) ;
le maintien ferme du tube à vide (26) en une position fixe par rapport à la tête d'outil (25) après que le tube à vide (26) a été poussé jusque dans la position rétractée au sein de la tête d'outil (25), le tube à vide (26) étant fermement maintenu dans la position fixe par un ensemble de saisie (60) qui comprend une douille (61), mobile le long d'un mandrin (62), l'ensemble de saisie (60) comprenant, en outre, une molette de mandrin (63) pour faire tourner manuellement le tube à vide (26) autour d'un axe s'étendant longitudinalement au travers dudit tube ;
le relevage de la tête d'outil (25), relevant ainsi le composant (20) avec le tube à vide (26) ;
le positionnement de la tête d'outil (25) au-dessus de la surface cible (31) ;
l'abaissement de la tête d'outil (25) de sorte qu'une surface inférieure du composant (20) est positionnée en contact avec la surface cible (31) ; et
la libération du composant (20) depuis le tube à vide (26).

6. Procédé selon la revendication 5, dans lequel le tube à vide (26) est fermement maintenu en une position fixe par rapport à la tête d'outil (25) après que le tube à vide (26) a été poussé jusque dans la position rétractée au sein de la tête d'outil (25), par :
déplacement d'une douille (61) le long d'un mandrin (62) au sein de la tête d'outil (25).

7. Procédé selon la revendication 5, dans lequel le composant (20) comprend un composant électronique.

8. Procédé selon la revendication 7, dans lequel le composant électronique (20) comprend une puce de circuit intégré.

9. Procédé selon la revendication 5, dans lequel la surface cible (31) comprend une carte de circuit imprimé (30).

10. Procédé selon la revendication 9, comprenant, en outre :
la mise en place de la carte de circuit imprimé (30) sur une plateforme pour composants (35) mobile ; et
le positionnement de la carte de circuit imprimé (30) en déplaçant la plateforme pour composants (35).
